# EUROPÄISCHE PATENTSCHRIFT

(11) **EP 0 902 541 B1**
(45) Veröffentlichungstag und Bekanntmachung des Hinweises auf die Patenterteilung: **22.10.2003**
(21) Anmeldenummer: 98115647.4
(22) Anmeldetag: 19.08.1998
(51) Int. Cl.: H03K 19/017

(54) **Pegelumsetzschaltung**
Level Shifter
Décaleur de niveau de tension

(30) Priorität: 10.09.1997 DE 19739807
(43) Veröffentlichungstag der Anmeldung: 17.03.1999
(73) Patentinhaber: Infineon Technologies AG, 81669 München (DE)
(72) Erfinder: Manyoki, Zoltan, 81739 München (DE)
(74) Vertreter: Epping, Wilhelm, Dipl.-Ing.

(56) Entgegenhaltungen:
- EP-A- 0 675 602
- US-A- 4 071 783
- US-A- 4 656 373
- US-A- 4 695 744

## Beschreibung

Die Erfindung betrifft eine Pegelumsetzschaltung.

Insbesondere in integrierten Schaltkreisen werden des öfteren Schaltungsteile miteinander gekoppelt, die einander gegenüber unterschiedliche Signalpegel benötigen bzw. abgeben. Zur Anpassung an die unterschiedlichen Signalpegel aneinander werden üblicherweise Pegelumsetzschaltungen eingefügt. Die Pegelumsetzschaltung sollte dabei nicht langsamer sein als die restlichen Schaltungsteile.

Aufgabe der Erfindung ist es daher, eine Pegelumsetzschaltung mit hoher Schaltgeschwindigkeit anzugeben.

Die Erfindung wird durch eine Pegelumsetzschaltung gemäß Patentanspruch 1 gelöst. Ausgestaltungen und Weiterbildungen des Erfindungsgedankens sind Gegenstand von Unteransprüchen.

Eine erfindungsgemäße Pegelumsetzschaltung umfaßt insbesondere einen ersten Transistor und einen zweiten Transistor, die beide vom ersten Leitungstyp sind. Die Steueranschlüsse beider Transistoren sind über die Laststrecke des jeweils anderen Transistors an ein erstes Versorgungspotential angeschlossen. Die Laststrecke eines dritten Transistors vom zweiten Leitungstyp ist zwischen den Steueranschluß des ersten Transistors und ein Bezugspotential geschaltet. Der Steueranschluß des dritten Transistors ist mit dem Eingang der Pegelumsetzschaltung gekoppelt. Dabei bildet der Knotenpunkt von zweitem und drittem Transistor den Ausgang der Pegelumsetzschaltung. Die Laststrecke eines vierten Transistors vom zweiten Leitungstyp ist zwischen den Steueranschluß des zweiten Transistors und den Steueranschluß des dritten Transistors geschaltet. Eine Kapazität ist dabei zwischen die Steueranschlüsse von drittem und viertem Transistor gesetzt.

Schließlich ist dem Steueranschluß des vierten Transistors eine Begrenzerschaltung vorgeschaltet.

Die Kapazität wirkt als Bootstrap-Kapazität, die kurzzeitig das Ansteuersignal am Steueranschluß des zweiten Transistors erhöht. Der vierte Transistor dient dazu, das erste Versorgungspotential und das Bezugspotential an der gesteuerten Strecke des ersten Transistors von einander zu isolieren. Das heißt, der vierte Transistor soll einen Stromfluß vom ersten Versorgungspotential zum Bezugspotential bei durchgeschaltetem ersten Transistor verhindern. Dadurch würde aber der zweite Transistor zum Abschalten nur mit einer um den Spannungsabfall über dem vierten Transistor verminderten Spannung angesteuert. Er würde daher verhältnismäßig langsam abgeschaltet werden. Die Bootstrap-Kapazität erhöht die Spannung kurzzeitig und beschleunigt dadurch das Abschalten.

Die Begrenzerschaltung ist derart ausgestaltet, daß sie ein kurzzeitiges Ansteigen der Steuerspannung für den zweiten Transistor auf einen bestimmten Wert zuläßt und ansonsten die Spannung auf einen bestimmten Wert begrenzt. Dadurch wird verhindert, daß am Steueranschluß des zweiten und vierten Transistors unzulässig hohe Spannungen auftreten. Die Begrenzerschaltung ist nur im "Problembereich" der Pegelumsetzschaltung aktiv, beeinflußt aber das sonstige Verhalten der Pegelumsetzschaltung nicht.

Die Begrenzerschaltung umfaßt bevorzugt einen fünften Transistor, dessen Steueranschluß mit dem Bezugspotential verbunden ist und dessen gesteuerte Strecke zwischen den Steueranschluß des vierten Transistors und ein zweites Versorgungspotential geschaltet ist. Weiterhin ist eine Diode vorgesehen, die in Durchlaßrichtung der gesteuerten Strecke des fünften Transistors parallel geschaltet ist.

Weiterhin kann die gesteuerte Strecke eines sechsten Transistors, dessen Steueranschluß mit dem Ausgang gekoppelt ist, der gesteuerten Strecke des fünften Transistors parallel geschaltet werden.

Die Kopplung des Steueranschlusses des sechsten Transistors und des Ausgangs erfolgt bevorzugt mittels eines Buffers, der beispielsweise aus zwei hintereinander geschalteten Invertern bestehen kann.

Darüber hinaus kann eine zweite Diode in Sperr-Richtung zwischen das Bezugspotential und den Steueranschluß des vierten Transistors geschaltet werden, um das Auftreten unzulässiger Potentiale am Steueranschluß des vierten Transistors zu unterbinden.

Bevorzugt wird dem Steuereingang des dritten Transistors ein Buffer vorgeschaltet, der dazu vorgesehen ist, zum einen definierte Eingangsverhältnisse für ein an den Eingang anzulegendes Eingangssignal zu schaffen und zum anderen eine niederohmige Ansteuerung des dritten Transistors und der Bootstrap-Kapazität zu gewährleisten.

Bevorzugt werden für die verwendeten Transistoren MOS-Feldeffekttransistoren eingesetzt. Diese zeichnen sich durch einen geringen Platzbedarf sowie durch geringe Verlustleistungen aus.

Bei einer Weiterbildung der Erfindung ist insbesondere der vierte Transistor ein MOS-Feldeffekttransistor. Dessen Gate-Source-Kapazität ist entsprechend ausgestaltet, um die Bootstrap-Kapazität zu bilden. Die Bootstrap-Kapazität erfordert dann nur einen geringen zusätzlichen Aufwand, da lediglich die die Gate-Source-Kapazität des vierten Transistors bestimmenden Strukturen entsprechend abgeändert werden müssen, um die gewünschte Kapazitätserhöhung zu erzielen.

Die Bootstrap-Kapazität kann jedoch auch durch einen zusätzlichen Kondensator gebildet werden, der beispielsweise durch die Gate-Source-Kapazität eines weiteren Feldeffekttransistors gegeben ist.

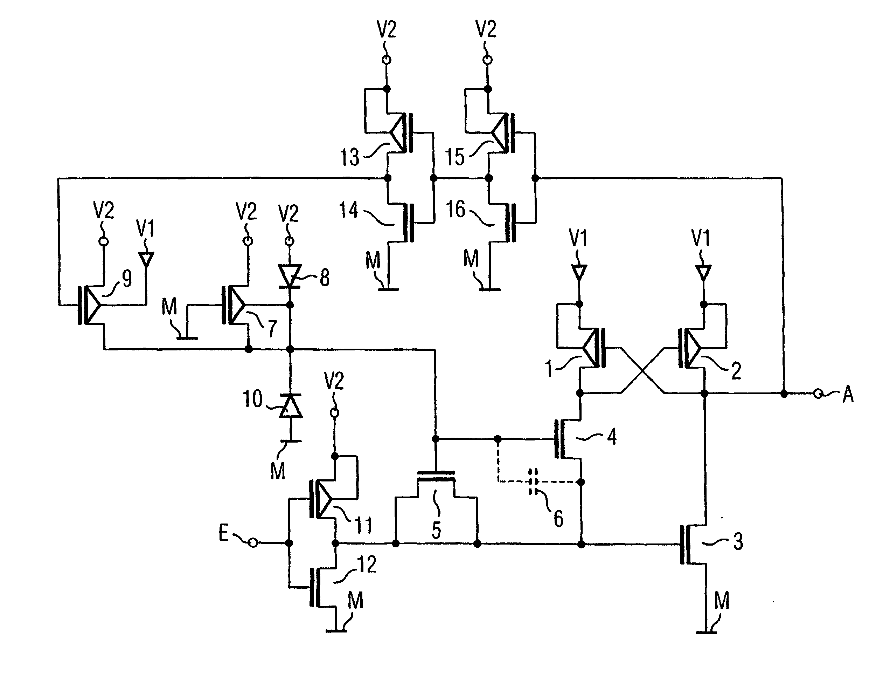

Die Erfindung wird nachfolgend anhand des in der einzigen Figur der Zeichnung dargestellten Ausführungsbeispiels näher erläutert.

Beim Ausführungsbeispiel sind ein MOS-Feldeffekttransistor 1 vom p-Kanal-Typ und ein MOS-Feldeffekttransistor 2 vom p-Kanal-Typ derart miteinander verschaltet, daß der Gateanschluß des Transistors 1 mit dem Drainanschluß des Transistors 2 und der Gateanschluß des Transistors 2 mit dem Drainanschluß des Transistors 1 verbunden ist. Die Sourceanschlüsse der beiden Transistoren 1 und 2 sind dabei an ein positives erstes Versorgungspotential V1 angeschlossen. Der Drainanschluß des Transistors 2 ist darüber hinaus mit einem Ausgangsanschluß A der Pegelumsetzschaltung sowie mit dem Drainanschluß eines MOS-Feldeffekttransistors 3 vom n-Kanal-Typ verschaltet. Der Gateanschluß des Transistors 3, dessen Sourceanschluß an ein Bezugspotential M angeschlossen ist, ist mit dem Sourceanschluß eines MOS-Feldeffekttransistors 4 vom n-Kanal-Typ verbunden, dessen Drainanschluß mit dem Drainanschluß des Transistors 1 gekoppelt ist.

Zwischen den Gateanschluß des Transistors 4 und den Gateanschluß des Transistors 3 ist ein durch einen entsprechend verschalteten MOS-Feldeffekttransistor vom einen Leitungstyp gebildeter Kondensator 5 geschaltet, dem die Gate-Source-Kapazität des Transistors 4 parallel liegt. Die Gate-Source-Kapazität des Transistors 4 ist dabei durch entsprechende Ausgestaltung der Transistorstrukturen des Transistors 4 vergrößert. Anstelle beider Kapazitäten kann auch in gleicher Weise nur eine der beiden Kapazitäten verwendet werden.

Die Ansteuerung des Gateanschlusses des Transistors 4 erfolgt mittels einer Begrenzereinrichtung, die beim Ausführungsbeispiel aus einem MOS-Feldeffekttransistor 7 vom p-Kanal-Typ besteht, dessen Steueranschluß mit dem Bezugspotential M verbunden ist und dessen Drain-Source-Strecke zwischen den Gateanschluß des Transistors 4 und ein positives zweites Versorgungspotential V2 geschaltet ist. Beim Transistor 7 ist dabei der Drainanschluß mit dem Gateanschluß des Transistors 4 und der Sourceanschluß mit dem Versorgungspotential V2 verbunden. Der Drain-Source-Strecke des Transistors 7 ist eine Diode 8 in Durchlaßrichtung parallel geschaltet.

Weiterhin ist ein Transistor 9 vorgesehen, dessen Gateanschluß mit dem Ausgang A gekoppelt ist. und dessen gesteuerte Strecke der gesteuerten Strecke des Transistors 7 parallel geschaltet ist. Die Kopplung des Gateanschlusses des Transistors 9 und des Ausgangs A erfolgt mittels eines aus zwei hintereinander geschalteten Invertern bestehenden Buffers. Schließlich ist auch dem Gateanschluß des Transistors 3 ein durch einen Inverter gebildeter Buffer vorgeschaltet.

Jeder der drei Inverter umfaßt dabei zwei in Gegentakt betriebene MOS-Feldeffekttransistoren, einen Transistor 11 bzw. 13 bzw. 15 vom p-Kanal-Typ und einen Transistor 12 bzw. 14 bzw. 16 vom n-Kanal-Typ. Die Gateanschlüsse und die Drainanschlüsse beider Transistoren sind jeweils miteinander verschaltet, wobei die beiden gekoppelten Drainanschlüsse den Ausgang der Inverterschaltung und die beiden gekoppelten Gateanschlüsse den Eingang der Inverterschaltung bilden. Die Sourceanschlüsse sind entsprechend an das zweite Versorgungspotential V2 bzw. an das Bezugspotential M angeschlossen.

Schließlich ist eine Diode 10 in Sperr-Richtung zwischen das Bezugspotential M und den Gateanschluß des Transistors 4 geschaltet.

## Patentansprüche

1. Pegelumsetzschaltung
mit einem ersten Transistor (1) vom ersten Leitungstyp und einem zweiten Transistor (2) vom ersten Leitungstyp, deren Steueranschlüsse über die Laststrecke des jeweils anderen Transistors an ein erstes Versorgungspotential (V1) angeschlossen sind,
mit einem dritten Transistor (3) vom zweiten Leitungstyp, dessen Laststrecke zwischen den Steueranschluß des ersten Transistors (1) und ein Bezugspotential (M) geschaltet ist und dessen Steueranschluß mit dem Eingang (E) der Pegelumsetzschaltung gekoppelt ist, wobei der Knotenpunkt von zweitem (2) und drittem (3) Transistor den Ausgang (A) der Pegelumsetzschaltung bildet,
mit einem vierten Transistor (4) vom zweiten Leitungstyp, dessen Laststrecke zwischen den Steueranschluß des zweiten Transistors (2) und den Steueranschluß des dritten Transistors (3) geschaltet ist,
mit einer Kapazität (5, 6), die zwischen die Steueranschlüsse von drittem und viertem Transistor (3, 4) geschaltet ist, und
mit einer Begrenzerschaltung , die dem Steueranschluß des vierten Transistors (4) vorgeschaltet ist.

2. Pegelumsetzschaltung nach Anspruch 1, bei der die Begrenzerschaltung aufweist:
einen fünften Transistor (7), dessen Steueranschluß mit dem Bezugspotential (M) verbunden ist und dessen gesteuerte Strecke zwischen den Steueranschluß des vierten Transistors (4) und ein zweites Versorgungspotential (V2) geschaltet ist, und
eine erste Diode (8), die in Durchlaßrichtung der gesteuerten Strecke des fünften Transistors (7) parallel geschaltet ist.

3. Pegelumsetzschaltung nach Anspruch 2 mit
einem sechsten Transistor (9), dessen Steueranschluß mit dem Ausgang (A) gekoppelt ist und dessen gesteuerte Strecke der gesteuerten Strecke des fünften Transistors (7) parallel geschaltet ist.

4. Pegelumsetzschaltung nach Anspruch 3, bei der
die Kopplung des Steueranschlusses des sechsten Transistors (9) und des Ausgangs (A) mittels eines ersten Buffers (13 ··· 16) erfolgt.

5. Pegelumsetzschaltung nach einem der Ansprüche 2 bis 4
mit einer zweiten Diode (10), die in Sperr-Richtung zwischen das Bezugspotential (M) und den Steueranschluß des vierten Transistors (4) geschaltet ist.

6. Pegelumsetzschaltung nach einem der vorherigen Ansprüche, bei der
dem Steuereingang des dritten Transistors (3) ein zweiter Buffer (11, 12) vorgeschaltet ist.

7. Pegelumsetzschaltung nach einem der vorherigen Ansprüche, bei der
zumindest ein Teil der Transistoren (1, 2, 3, 4, 7, 9) MOS-Feldeffekttransistoren sind.

8. Pegelumsetzschaltung nach einem der vorherigen Ansprüche , bei der
der vierte Transistor (4) ein MOS-Feldeffekttransistor ist und
die Kapazität (5, 6) durch eine entsprechend ausgebildete Gate-Source-Kapazität des vierten Transistors (4) gebildet wird.

9. Pegelumsetzschaltung nach einem der vorherigen Ansprüche , bei der
die Kapazität (5, 6) durch einen Kondensator (5) gebildet wird.

10. Pegelumsetzschaltung nach Anspruch 9, bei der
die Kapazität (5) durch die Gate-Source-Kapazität eines weiteren Feldeffekttransistors gebildet wird.

## Claims

1. Level converting circuit
having a first transistor (1) of the first conductivity type and a second transistor (2) of the first conductivity type, the control terminals of which transistors are connected to a first supply potential (V1) via the load path of the respective other transistor,
having a third transistor (3) of the second conductivity type whose load path is connected between the control terminal of the first transistor (1) and a reference potential (M) and whose control terminal is coupled to the input (E) of the level converting circuit, the node between second (2) and third (3) transistor forming the output (A) of the level converting circuit,
having a fourth transistor (4) of the second conductivity type, whose load path is connected between the control terminal of the second transistor (2) and the control terminal of the third transistor (3),
having a capacitance (5, 6), which is connected between the control terminals of third and fourth transistors (3, 4), and
having a limiter circuit, which is connected upstream of the control terminal of the fourth transistor (4).

2. Level converting circuit according to Claim 1, in which the limiter circuit has:
a fifth transistor (7), whose control terminal is connected to the reference potential (M) and whose controlled path is connected between the control terminal of the fourth transistor (4) and a second supply potential (V2), and
a first diode (8), which is connected in parallel in the forward direction with the controlled path of the fifth transistor (7).

3. Level converting circuit according to Claim 2, having
a sixth transistor (9), whose control terminal is coupled to the output (A) and whose controlled path is connected in parallel with the controlled path of the fifth transistor (7).

4. Level converting circuit according to Claim 3, in which
the coupling of the control terminal of the sixth transistor (9) and of the output (A) is effected by means of a first buffer (13 ... 16).

5. Level converting circuit according to one of Claims 2 to 4,
having a second diode (10), which is connected in the reverse direction between the reference potential (M) and the control terminal of the fourth transistor (4).

6. Level converting circuit according to one of the preceding claims, in which
a second buffer (11, 12) is connected upstream of the control input of the third transistor (3).

7. Level converting circuit according to one of the preceding claims, in which
at least some of the transistors (1, 2, 3, 4, 7, 9) are MOS field-effect transistors.

8. Level converting circuit according to one of the preceding claims, in which
the fourth transistor (4) is a MOS field-effect transistor, and
the capacitance (5, 6) if formed by a correspondingly designed gate-source capacitance of the fourth transistor (4).

9. Level converting circuit according to one of the preceding claims, in which
the capacitance (5, 6) is formed by a capacitor (5).

10. Level converting circuit according to Claim 9, in which
the capacitance (5) is formed by the gate-source capacitance of a further field-effect transistor.

## Revendications

1. Décaleur de niveau de tension
comprenant un premier transistor (1) d'un premier type de conductivité et un deuxième transistor (2) du premier type de conductivité, dont les bornes de commande sont reliées par la section de charge de l'autre transistor respectif à un premier potentiel (V1) d'alimentation,
comprenant un troisième transistor (3) du deuxième type de conductivité, dont la section de charge est montée entre la borne de commande du premier transistor (1) et un potentiel (M) de référence et dont la borne de commande est couplée à l'entrée (E) du décaleur de niveau de tension, le noeud du deuxième (2) et du troisième (3) transistor formant la sortie (A) du décaleur de niveau de tension,
comprenant un quatrième transistor (4) du deuxième type de conductivité, dont la section de charge est montée entre la borne de commande du deuxième transistor (2) et la borne de commande du troisième transistor (3),
comprenant une capacité (5, 6) qui est montée entre les bornes de commande du troisième et du quatrième transistor (3, 4), et
comprenant un circuit limiteur qui est monté en amont de la borne de commande du quatrième transistor (4).

2. Décaleur de niveau de tension suivant la revendication 1, dans lequel le circuit limiteur comprend :
un cinquième transistor (7) dont la borne de commande est reliée au potentiel (M) de référence et dont la section commandée est montée entre la borne de commande du quatrième transistor (4) et un deuxième potentiel (V2) d'alimentation, et
une première diode (8) qui est montée en parallèle dans le sens passant de la section commandée du cinquième transistor (7).

3. Décaleur de niveau de tension suivant la revendication 2, comprenant
un sixième transistor (9) dont la borne de commande est couplée à la sortie (A) et dont la section commandée est montée en parallèle à la section commandée du cinquième transistor (7).

4. Décaleur de niveau de tension suivant la revendication 3, dans lequel
le couplage de la borne de commande du sixième transistor (9) et de la sortie (A) s'effectue au moyen d'un premier tampon (13...16).

5. Décaleur de niveau de tension suivant l'une des revendications 2 à 4,
comprenant une deuxième diode (10) qui est montée dans le sens bloqué entre le potentiel (M) de référence et la borne de commande du quatrième transistor (4).

6. Décaleur de niveau de tension suivant l'une des revendications précédentes, dans lequel
il est monté en amont de l'entrée de commande du troisième transistor (3) un deuxième tampon (11, 12).

7. Décaleur de niveau de tension suivant l'une des revendications précédentes, dans lequel
au moins une partie des transistors (1, 2, 3, 4, 7, 9) sont des transistors à effet de champ MOS.

8. Décaleur de niveau de tension suivant l'une des revendications précédentes, dans lequel
le quatrième transistor (4) est un transistor à effet de champ MOS et
la capacité (5, 6) est formée par une capacité grille-source constituée de manière adéquate du quatrième transistor (4).

9. Décaleur de niveau de tension suivant l'une des revendications précédentes, dans lequel
la capacité (5, 6) est formée par un condensateur (5).

10. Décaleur de niveau de tension suivant la revendication 9, dans lequel
la capacité (5) est formée par la capacité grille-source d'un autre transistor à effet de champ.
